(19)

**Europäisches Patentamt**
**European Patent Office**
**Office européen des brevets**

(11) **EP 4 760 289 A1**

(12) **EUROPEAN PATENT APPLICATION**

(43) Date of publication:
**17.06.2026 Bulletin 2026/25**

(21) Application number: **24307092.7**

(22) Date of filing: **12.12.2024**

(51) International Patent Classification (IPC):
**G01R 31/34** *(2020.01)*

(52) Cooperative Patent Classification (CPC):
**G01R 31/343**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Schneider Toshiba Inverter Europe SAS**
**27120 Pacy-sur-Eure (FR)**

(72) Inventors:
• **AWDE, Ahmad**
 **27200 VERNON (FR)**
• **SAKR, Georges**
 **76130 MONT SAINT AIGNAN (FR)**
• **TFAILY, Ali**
 **92500 RUEIL MALMAISON (FR)**
• **JEBAI, Al Kassem**
 **27200 VERNON (FR)**

(74) Representative: **Plasseraud IP**
 **104 Rue de Richelieu**
 **CS92104**
 **75080 Paris Cedex 02 (FR)**

(54) **METHOD, SYSTEM AND COMPUTER PROGRAM FOR DETECTING FAULTS IN INDUCTION MOTORS**

(57)    A method, system, and computer program for detecting faults in induction motors using Electric Signal Analysis (ESA) and Fast Fourier Transform (FFT) techniques is disclosed. The method involves receiving an input signal (10) from the induction motor, transforming the input signal into the frequency domain using FFT (11) to obtain an FFT spectrum, applying an envelope detection algorithm (12-15) to the FFT spectrum to obtain an envelope representing amplitude variations of frequency components, calculating (16) the Root Mean Square (RMS) of the envelope, and analyzing the calculated RMS envelope (17) to detect at least one frequency signature representative of a fault in the induction motor. The method enhances fault detection capabilities by addressing noise sensitivity and resolution limitations of traditional FFT-based ESA techniques.

Fig. 1

**EP 4 760 289 A1**

## Description

### Technical Field

This disclosure pertains to the field of predictive maintenance technologies, specifically to fault detection in induction motors using Electric Signal Analysis (ESA) and Fast Fourier Transform (FFT) techniques.

### Background Art

Predictive maintenance technologies involve the use of advanced monitoring and diagnostic tools to predict equipment failures before they occur. These technologies aim to reduce downtime, improve operational efficiency, and enhance workplace safety by providing real-time data on the condition of machinery. Predictive maintenance relies on various techniques, including vibration analysis, thermal imaging, and electric signal analysis, to monitor the health of equipment and identify potential issues early.

Predictive maintenance technologies aim to ensure the continuous and efficient operation of industrial equipment. By monitoring the condition of machinery, facility managers can schedule maintenance activities based on the actual needs of the equipment rather than on a fixed schedule. This approach helps to prevent unexpected failures, reduce maintenance costs, and extend the lifespan of the equipment. In the context of induction motors, predictive maintenance focuses on detecting common faults such as misalignment and broken rotor bars, which can lead to significant operational disruptions if not addressed promptly.

An induction motor is an electric motor that operates on the principle of electromagnetic induction, where the electric current required to produce torque is generated by electromagnetic induction from the magnetic field of the stator winding. It typically consists of a stator, which produces a rotating magnetic field, and a rotor, which is induced by this field to create motion. Induction motors are widely used in industrial and commercial applications due to their robustness, reliability, and simplicity of construction.

Induction motors are widely used in various industrial, commercial, and residential applications due to their robustness, reliability, and simplicity of construction. They find industrial applications in the field of pumps, conveyors, compressors, machine tools, as well as fans and blowers for example. They can also be used, among others, to drive elevators and escalators, or in electric vehicles.

Electric Signal Analysis (ESA) is a widely used technique in predictive maintenance for induction motors. ESA involves analyzing the current and voltage signals of the motor in the frequency domain using the Fast Fourier Transform (FFT). By examining the frequency components of these signals, it is possible to identify characteristic fault signatures that indicate the presence of specific defects. This method, which, so far, has always been based on an analysis of the amplitude of the fault frequency components, provides valuable insights into the condition of the motor and helps to detect faults at an early stage.

Despite the effectiveness of ESA and FFT in fault detection, these methods face several challenges that can limit their accuracy and reliability. Notably, although several studies have been conducted using FFT, they are all faced with difficulties in finding the fault characteristic frequency component.

In "Fault Detection of Induction Motor Using Fast Fourier Transform with Feature Selection via Principal Component Analysis", International Journal of Precision Engineering and Manufacturing, vol. 20, no. 9, pp. 1543-1553, 2019, Young-Jun Yoo suggests a method comprising computing FFT signals of current data of an induction motor and using a Principal Component Analysis (PCA) to find the probability bounds of the changes of the peak frequencies and corresponding values of the FFT through Hotelling's $T^2$ value. This allows to detect a fault in the induction motor by reducing the dimension of the fault characteristic frequency component (FCFC) using the PCA. Hotelling's $T^2$ can be used as an index for detecting faults, such as broken bar or broken end-ring connector state.

Though interesting, this method suffers from the same drawbacks as the other prior art solutions based on ESA through FFT.

Indeed, noise sensitivity is a significant issue, as FFT can be highly susceptible to noise, making it difficult to distinguish between fault signals and background noise. Additionally, the resolution of FFT is constrained by the length of the analyzed signal, which can result in insufficient frequency resolution for accurately identifying faults. Shorter signals may not provide enough frequency resolution to identify faults accurately. These limitations necessitate the development of improved techniques to enhance fault detection in induction motors.

There is thus a need for a method that enhances the fault detection capabilities of ESA by addressing the noise sensitivity and resolution limitations of FFT.

### Summary

This disclosure improves the situation.

It is proposed a method for detecting faults in an induction motor, comprising:

receiving an input signal from the induction motor;

transforming the input signal into the frequency domain using a Fast Fourier Transform, FFT, to obtain an FFT spectrum;

applying an envelope detection algorithm to the FFT spectrum to obtain an envelope representing amplitude variations of frequency components of the FFT spectrum;

calculating the Root Mean Square, RMS, of the envelope;

analyzing the calculated RMS envelope to detect at least one frequency signature representative of a fault in the induction motor, called a fault signature.

In another aspect, it is proposed a system for detecting faults in an induction motor, comprising:

a signal acquisition module configured to receive an input signal from the induction motor;
a processing unit configured to:

transform the input signal into the frequency domain using a Fast Fourier Transform, FFT, to obtain an FFT spectrum;

apply an envelope detection algorithm to the FFT spectrum to obtain an envelope representing amplitude variations of frequency components of the FFT spectrum;

calculate the Root Mean Square, RMS, of the envelope;

analyze the calculated RMS envelope to detect at least one frequency signature representative of a fault in the induction motor, called a fault signature.

In another aspect, it is proposed a computer software comprising instructions to implement at least a part of a method as defined here when the software is executed by a processor. In another aspect, it is proposed a computer-readable non-transient recording medium on which a software is registered to implement the method as defined here when the software is executed by a processor.
The following features, can be optionally implemented, separately or in combination one with the others:
Applying an envelope detection algorithm to the FFT spectrum comprises:

- rectifying the FFT spectrum;
- smoothing the rectified FFT spectrum with a low-pass filter to obtain the envelope.

The detected faults belong to the group comprising:

- misalignment faults;
- broken rotor bar faults.

Analyzing the calculated RMS envelope comprises:

- calculating a total energy of the at least one fault signature by summing an harmonic fault area between a curve representative of the RMS envelope and an x-axis;
- outputting a fault indicator representative of the calculated total energy;
- comparing said fault indicator with a threshold to detect a fault when said fault indicator is over the threshold.

The input signal belongs to the group comprising:

- a voltage signal;
- a current signal;
- a reactive power signal;

- an active power signal.

The FFT spectrum is normalized before applying the envelope detection algorithm.

The processing unit is further configured to calculate a total energy of the at least one fault signature by summing an harmonic fault area between a curve representative of the RMS envelope and an x-axis, and the system further comprises a fault indicator module configured to output a fault indicator representative of the calculated total energy and compare the fault indicator with a threshold to detect a fault when the fault indicator is over the threshold;

The system for detecting faults further comprises a user interface configured to display fault detection results to an operator.

## Brief Description of Drawings

Other features, details and advantages will be shown in the following detailed description and on the figures, on which:

### Fig. 1

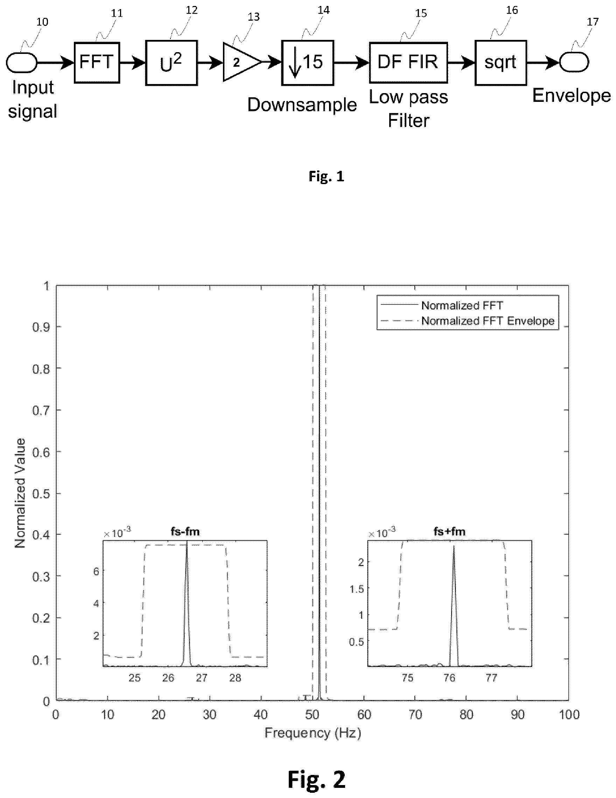

[Fig. 1] is a block diagram to compute the RMS envelope of the FFT spectrum of the input signal according to an embodiment.

### Fig. 2

[Fig. 2] shows a comparison of a FFT and its envelope for the current signal of a faulty motor with misalignment fault according to an embodiment.

### Fig. 3

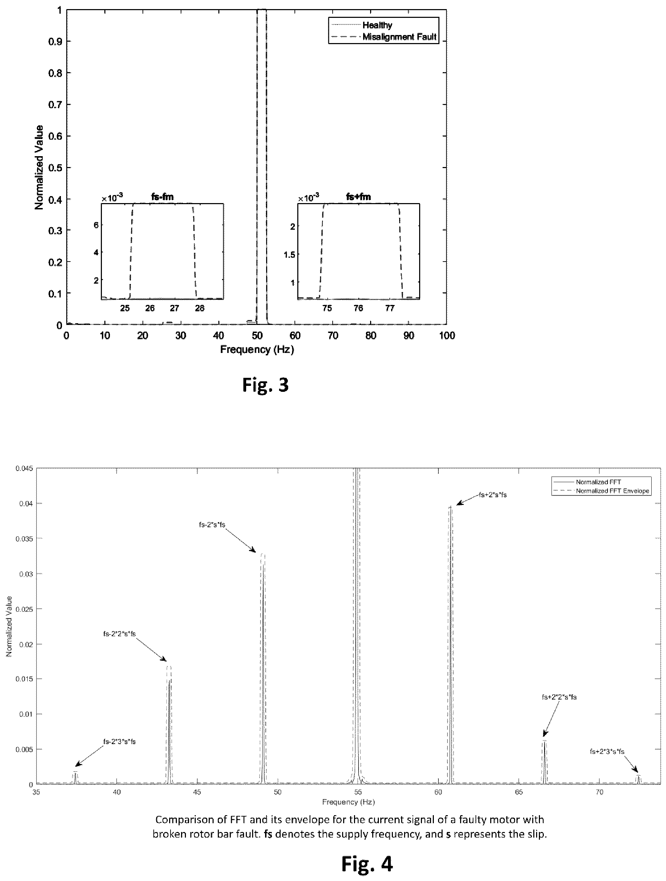

[Fig. 3] shows a comparison of the FFT envelope for an healthy motor and for a motor with misalignment fault according to an embodiment.

### Fig. 4

[Fig. 4] shows a comparison of a FFT and its envelope for the current signal of a faulty motor with broken rotor bar fault according to an embodiment.

### Fig. 5

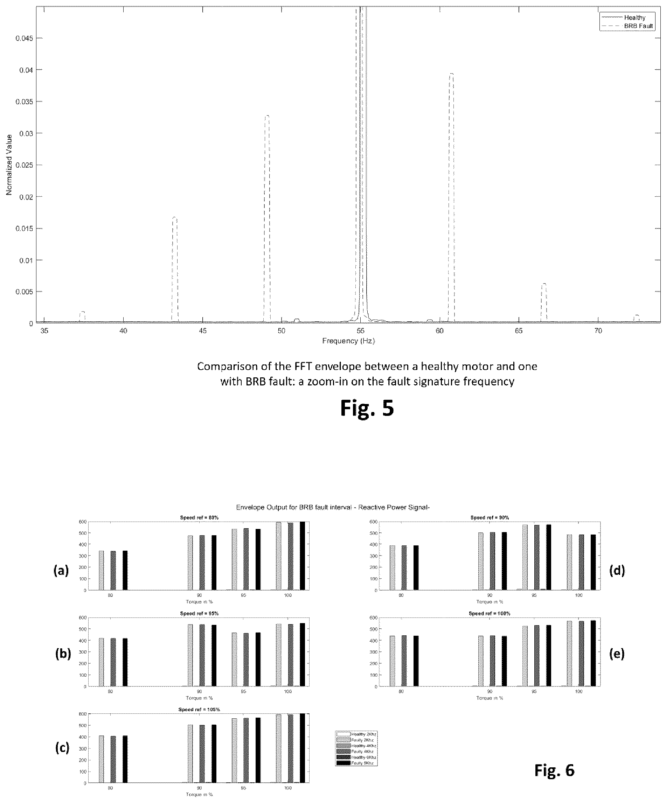

[Fig. 5] shows a comparison of the FFT envelope for an healthy motor and for a motor with broken rotor bar fault according to an embodiment.

### Fig. 6

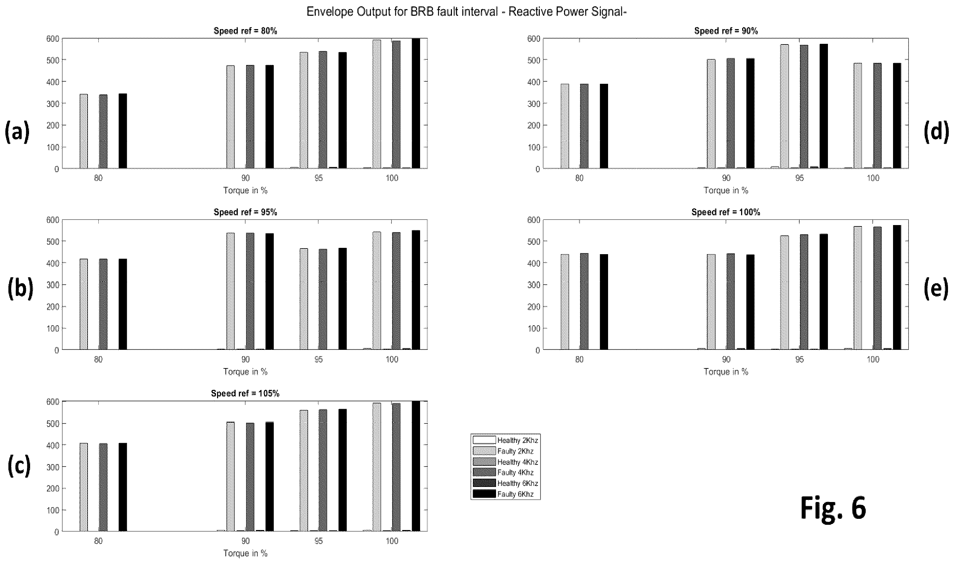

[Fig. 6] shows a set of fault indicators based on envelope energy of a reactive power signal for a 4-kw induction motor with three broken rotor bars according to an embodiment.

### Fig. 7

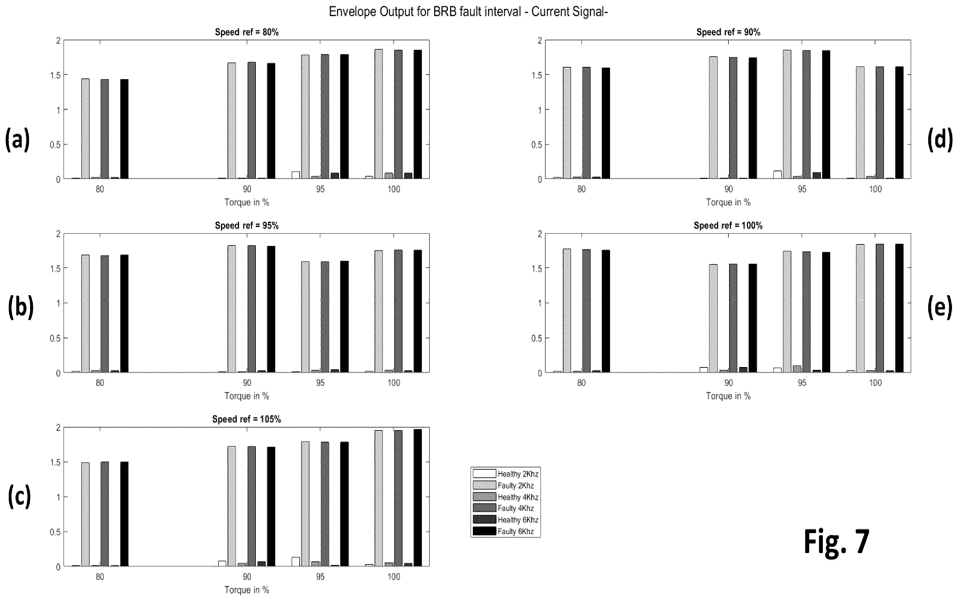

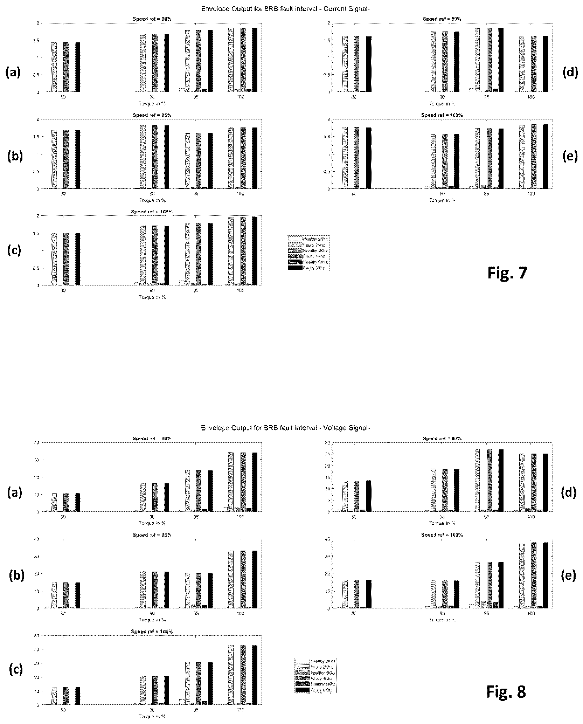

[Fig. 7] shows a set of fault indicators based on envelope energy of a current signal for a 4-kw induction motor with three broken rotor bars according to an embodiment.

### Fig. 8

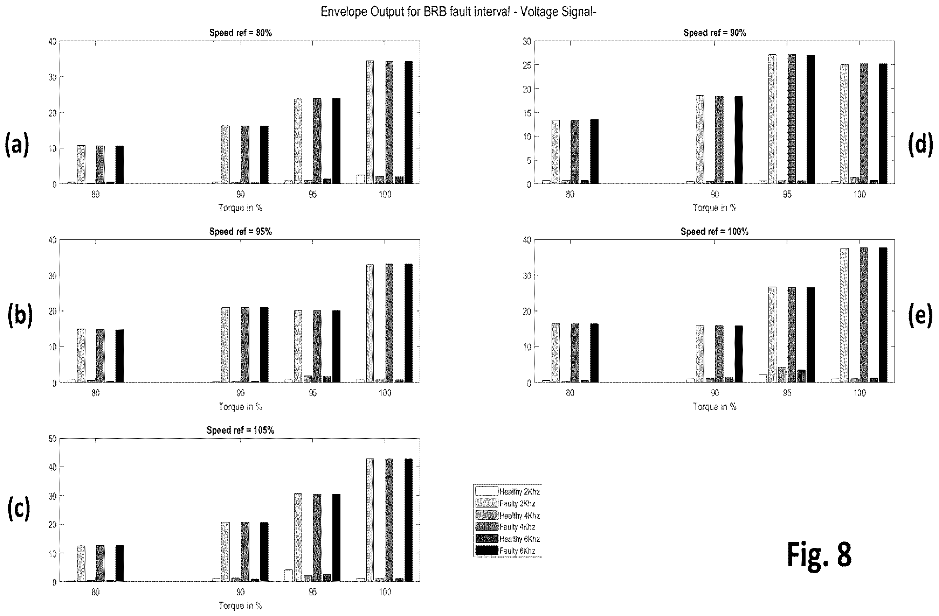

[Fig. 8] shows a set of fault indicators based on envelope energy of a voltage signal for a 4-kw induction motor with three broken rotor bars according to an embodiment.

### Fig. 9

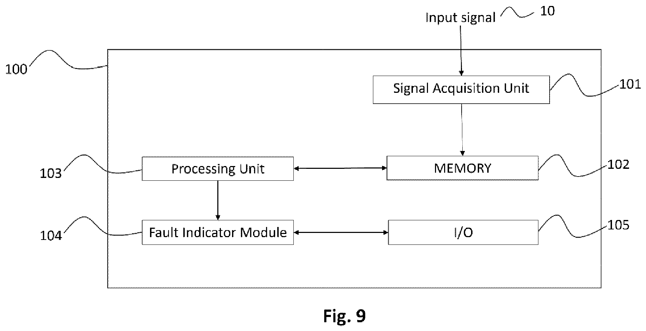

[Fig. 9] is a block diagram of a system for detecting faults according to an embodiment.

## Description of Embodiments

The general principle of the invention is to enhance the fault detection capabilities in induction motors by leveraging a combination of Electric Signal Analysis (ESA) and Fast Fourier Transform (FFT) techniques, augmented with an envelope detection algorithm. Envelope detection is a signal processing technique used to extract the envelope of a signal. The envelope represents the smooth curve that outlines the peaks of an oscillating signal. The method involves transforming the input signal from the induction motor into the frequency domain using FFT to obtain an FFT spectrum. An envelope detection algorithm is then applied to this spectrum, which may include rectifying and smoothing the FFT spectrum to obtain an envelope that represents the amplitude variations of the frequency components. By calculating the Root Mean Square (RMS) of this envelope, the method effectively reduces noise and highlights dominant frequency components. This enhanced frequency analysis allows for the accurate detection of fault signatures, such as misalignment and broken rotor bars, by emphasizing specific frequency components and providing a clearer and more interpretable frequency spectrum.

Indeed, each fault has a specific frequency signature, which is a specific pattern or set of frequencies that appear in the frequency spectrum of an electric signal when a particular fault occurs in an induction motor. The fault frequency signature may be seen as a "fingerprint" that helps identify the type of fault affecting the motor.

The present disclosure allows detecting specific frequency signatures in the calculated RMS envelope, that indicate faults in the induction motor, and monitoring changes in amplitudes of these detected fault signatures, which are representative of how the faults evolve over time.

It is now referred to figure 1, which shows a block diagram for calculating the RMS envelope of an input signal according to an embodiment of the method for detecting faults in an induction motor.

The input signal 10 represents the electrical signal acquired from the induction motor. This signal can be any electrical signal acquired from the motor, such as a voltage signal, a current signal, or an active or reactive power signal. A signal acquisition module (referenced as 101 on Fig. 9 described below in relation to a system for detecting faults) captures this input signal, which contains information about the motor's operational state. The input signal 10 serves as the initial data source for the subsequent processing steps, where the signal undergoes transformation and analysis to detect potential faults in the motor. This input signal 10 may be sampled at any frequency sampling rate (e.g. 2kHz, 4kHz, 6kHz...) without any significant impact on the efficiency of the fault detection, as will be shown in relation to figures 6 to 8.

A unit 11 for computing Fast Fourier Transform (FFT) converts the input signal 10 from the time domain to the frequency domain. This transformation results in an FFT spectrum that displays the frequency components of the input signal, and which is then rectified by unit 12. Rectification involves converting all negative values in the FFT spectrum to positive values, ensuring that the entire spectrum is positive. This can be done using full-wave rectification, where both the positive and negative halves of the signal are converted to positive, or half-wave rectification, where only the negative half is converted. This step prepares the signal for envelope detection, as the rectified FFT spectrum simplifies the subsequent smoothing process. The rectified FFT spectrum highlights the amplitude variations of the frequency components, which are necessary for fault detection.

A gain 13 amplifies the rectified FFT spectrum by a factor of two. This amplification enhances the signal's amplitude, making the signal easier to detect and analyze the dominant frequency components. The gain adjustment ensures that the signal's significant features are more pronounced, facilitating the identification of fault signatures in the induction motor.

A downsampling component 14 reduces the sampling rate of the amplified and rectified FFT spectrum. Downsampling involves selecting a subset of the data points, effectively decreasing the number of samples while retaining the characteristics of the signal. This step helps in managing the data size and computational load, making the subsequent processing steps more efficient. The downsampling factor may vary depending on the type of fault being analyzed, with different factors applied for misalignment and broken rotor bar faults (for example, a downsampling factor of 15 provides good results for misalignment faults, while a downsampling factor of 5 could be used for broken rotor bar faults, which are characterized by a greater number of sidebands in the fault signature).

A Low Pass Filter 15 then smooths the downsampled FFT spectrum by removing highfrequency noise components, which may have been introduced by the downsampling. This filtering process results in a smooth curve that represents the envelope of the FFT spectrum. The low pass filter 15 ensures that only the relevant low-frequency components, which correspond to the fault signatures, are retained. The cutoff frequency of the low pass filter is chosen based on the specific requirements of the fault detection process (e.g. 10 rad.s$^{-1}$).

Component 16 then calculates the Root Mean Square (RMS) of the smoothed envelope, by defining the window size. It is recalled that the Root Mean Square is a statistical measure of the magnitude of a varying signal, providing an average value that accounts for both positive and negative variations. The RMS calculation hence provides a measure of the magnitude of the varying envelope, effectively reducing noise and highlighting the dominant frequency components. This step enhances the clarity of the frequency spectrum and makes the fault signatures more discernible. The RMS value represents the overall energy of the envelope, which is used in the subsequent analysis to detect faults.

The final output of the envelope detection algorithm is an envelope 17, which outlines the amplitude variations of the frequency components in the FFT spectrum, providing a clear and interpretable representation of the signal's frequency content. The envelope 17 may also be derived using the RMS envelope function in Matlab®.

The envelope 17 is then analyzed to detect specific frequency signatures that indicate faults in the induction motor. By examining the envelope, the system can identify and monitor the evolution of faults such as misalignment and broken rotor bars, ensuring timely maintenance and preventing operational disruptions.

The method for detecting faults illustrated in Fig. 1 is particularly advantageous in applications such as machinery diagnostics, where it enhances the detection of faults by emphasizing specific frequency components, while also providing a clearer and more interpretable frequency spectrum. It offers a robust solution for fault detection in induction motors by addressing the noise sensitivity and resolution limitations of traditional FFT-based ESA techniques. The combination of FFT, envelope detection, and RMS calculation provides a clearer and more detailed representation of the signal's frequency content, leading to improved fault detection and diagnosis.

Indeed, fault detection in induction motors is crucial for maintaining operational efficiency and preventing unexpected failures. Two common faults are misalignment and broken rotor bars, each producing distinct signatures in the motor current spectrum.

An application to the detection of misalignment faults in an induction motor is now described in relation to figures 2 and 3.

A misalignment fault in an induction motor occurs when the motor's rotor and stator are not properly aligned. This misalignment can lead to uneven air gaps between the rotor and stator, which can affect the motor's magnetic field and reduce its efficiency, increased vibration and noise levels, and additional mechanical stress on the motor components. Misalignment faults generate specific harmonic components in the motor's current spectrum, which can be detected and analyzed to identify the fault.

The frequency of the misalignment fault signature can be represented by the equation:

[Math. 1]

$$f_{misalignment} = f_s \pm k \cdot f_m$$

where $f_{misalignment}$ is the frequency of the misalignment fault signature, $f_s$ is the supply frequency, $f_m$ is the mechanical rotor frequency, and k is an integer representing the harmonic order. It is recalled that harmonic components are frequencies that are integer multiples of a primary frequency, often appearing in the spectrum of a signal due to periodic disturbances.

Figure 2 illustrates a comparison between the normalized Fast Fourier Transform (FFT) spectrum and its corresponding normalized FFT envelope for the current signal of a faulty motor with a misalignment fault. The figure provides a visual representation of how the envelope detection algorithm enhances the fault detection process by highlighting the dominant frequency components.

Indeed, according to an embodiment, the FFT spectrum may be normalized before applying the envelope detection algorithm of Figure 1. Normalizing the FFT spectrum before applying the envelope detection algorithm ensures that the amplitude values of the frequency components are scaled to a common reference. This normalization process enhances the clarity of the signal by reducing the impact of variations in signal amplitude, making it easier to identify fault signatures.

Normalization also helps to mitigate the effects of noise in the FFT spectrum. By scaling the amplitude values, the method reduces the impact of random noise fluctuations, making the dominant frequency components more pronounced and easier to analyze. The normalization process also makes the method more robust to variations in the input signal. Changes in signal amplitude due to load variations, supply voltage fluctuations, or other factors are accounted for during normalization, ensuring that the fault detection process remains reliable under varying conditions.

In figure 2, the horizontal axis, or X-axis, represents the frequency components of the signal, ranging from 0 to 100 Hz. The vertical axis, or Y-axis, represents the normalized amplitude values of the frequency components. The solid line represents the normalized FFT spectrum of the current signal. This spectrum shows the frequency components of the signal, including the fault characteristic frequencies. The dotted line represents the normalized FFT envelope 17 obtained after applying the envelope detection algorithm. This envelope 17 outlines the amplitude variations of the frequency components, providing a clearer representation of the dominant frequencies.

The main graph shows a prominent peak at the supply frequency (around 50 Hz) and sidebands at $f_s \pm f_m$. These sidebands are characteristic of misalignment faults.

A left inset graph provides a zoomed-in view of the frequency component at $f_s - f_m$, where $f_s$ is the supply frequency and $f_m$ is the mechanical rotor frequency. The inset shows the normalized FFT (solid line) and the normalized FFT envelope 17 (dotted line) for this specific frequency component. A right inset graph provides a zoomed-in view of the frequency component at $f_s + f_m$. Similar to the left inset, it shows the normalized FFT (solid line) and the normalized FFT envelope 17 (dotted line) for this frequency component.

The envelope 17 highlights the amplitude variations more clearly, making the fault signature more discernible. Indeed, if the signal resolution decreases, the amplitude of the frequency peaks associated with the faults decrease as well, making them difficult to detect when working on the FFT (solid line), as was done in the prior art, rather than on the RMS envelope of the FFT (dotted line).

As is also apparent on Fig. 2, the envelope detection algorithm reduces the impact of noise, making the dominant frequency components more pronounced and easier to analyze.

Figure 3 illustrates a comparison of the FFT envelope 17 between a healthy motor and a motor with a misalignment fault. The figure provides a visual representation of how the envelope detection algorithm differentiates between the two conditions by highlighting the fault signatures in the frequency spectrum.

The horizontal axis, or X-Axis, represents the frequency components of the signal, ranging from 0 to 100 Hz. The vertical axis, or Y-Axis, represents the normalized amplitude values of the frequency components. The solid line represents the normalized FFT envelope of the current signal for a healthy motor. This line serves as a baseline for comparison. The dotted line represents the normalized FFT envelope of the current signal for a motor with a misalignment fault. This line shows the presence of fault signatures in the frequency spectrum.

The left inset graph provides a zoomed-in view of the frequency component at $f_s - f_m$, where $f_s$ is the supply frequency and $f_m$ is the mechanical rotor frequency. The inset shows the normalized FFT envelope for both the healthy motor (solid line) and the motor with a misalignment fault (dotted line). The fault signature is clearly visible in the dotted line, indicating the presence of a misalignment fault.

The right inset graph provides a zoomed-in view of the frequency component at $f_s + f_m$. Similar to the left inset, it shows the normalized FFT envelope for both the healthy motor (solid line) and the motor with a misalignment fault (dotted line). The fault signature is again visible in the dotted line, confirming the presence of a misalignment fault.

The main graph shows a prominent peak at the supply frequency (around 50 Hz) and sidebands at $f_s \pm f_m$. These sidebands are characteristic of misalignment faults.

The dotted line (misalignment fault) shows significant amplitude variations at the fault characteristic frequencies ($f_s - f_m$ and $f_s + f_m$), which are not present in the solid line (healthy motor). This indicates the presence of a misalignment fault and constitutes a fault signature.

Overall, Figure 3 demonstrates the effectiveness of the envelope detection algorithm in distinguishing between a healthy motor and a motor with a misalignment fault. The clear visualization of fault signatures in the frequency spectrum aids in the accurate detection and diagnosis of misalignment faults in induction motors.

As regards misalignment faults, it may be enough to focus on the first harmonics, or first two harmonics only, the following ones having less significant values. Notably, the second harmonic may be superimposed with an electric harmonic, as it happens that $f_s + f_m = 2f_s$, and it may be better to focus only on the first harmonic. As will be shown in relation to figures 6 to 8, an indicator may be computed as the sum of the total energy of the faults areas for the selected harmonics.

An application to the detection of broken rotor bar faults in an induction motor is now described in relation to figures 4 to 8, and is based on an example of a 4-kW induction motor with three Broken Rotor Bars.

A broken rotor bar fault in an induction motor occurs when one or more bars in the rotor cage break or become damaged. This fault disrupts the uniform magnetic field required for efficient motor operation, leading to reduced performance, increased vibration, and potential overheating. Broken rotor bar faults produce fault signatures characterized by sidebands around the supply frequency. The frequency of these sidebands can be represented by the equation:

[Math. 2]

$$f_{brb} = f_s(1 \pm 2Ks)$$

where $f_{brb}$ is the frequency of the broken rotor bar fault signature, $f_s$ is the supply frequency, s is the slip of the motor, and K is an integer representing the harmonic order.

Slip in an induction motor refers to the difference between the synchronous speed (the speed of the rotating magnetic field in the stator) and the actual speed of the rotor. Slip is a crucial parameter in the operation of induction motors, as it determines the torque and efficiency of the motor. It is typically expressed as a percentage of the synchronous speed. It may be expressed by the following equation:

[Math. 3]

$$s = \frac{N_s - N_r}{N_s}$$

where $N_s$ is the synchronous speed and $N_r$ is the rotor speed. The rotor speed is always slightly less than the synchronous speed due to the slip. The synchronous speed $N_s$ is determined by the supply frequency $f_s$ and the number of poles in the motor.

Figure 4 illustrates a comparison of the normalized Fast Fourier Transform (FFT) spectrum and its corresponding normalized FFT envelope for the current signal of a faulty motor with a broken rotor bar fault. The figure provides a visual representation of how the envelope detection algorithm enhances the fault detection process by highlighting the dominant

frequency components associated with the broken rotor bar fault.

The horizontal axis, or X-Axis, represents the frequency components of the signal, ranging from 30 to 75 Hz. The vertical axis, or Y-axis, represents the normalized amplitude values of the frequency components. The solid line represents the normalized FFT spectrum of the current signal. This spectrum shows the frequency components of the signal, including the fault characteristic frequencies. The dotted line represents the normalized FFT envelope obtained after applying the envelope detection algorithm of Fig. 1.

The main graph shows prominent peaks at the supply frequency ($f_s$) and sidebands at $f_s \pm 2Ksf_s$. These sidebands are characteristic of broken rotor bar faults and are labeled on the graph:

$$f_s - 2 * s * f_s$$

$$f_s - 2 * 2 * s * f_s$$

$$f_s - 2 * 3 * s * f_s$$

$$f_s + 2 * s * f_s$$

$$f_s + 2 * 2 * s * f_s$$

$$f_s + 2 * 3 * s * f_s$$

Figure 5 illustrates a comparison of the FFT envelope between a healthy motor and a motor with a broken rotor bar (BRB) fault. The figure provides a visual representation of how the envelope detection algorithm differentiates between the two conditions by highlighting the fault signatures in the frequency spectrum.

The horizontal axis, or X-Axis, represents the frequency components of the signal, ranging from 0 to 100 Hz. The vertical axis, or Y-Axis, represents the normalized amplitude values of the frequency components. The solid line represents the normalized FFT envelope of the current signal for a healthy motor. This line serves as a baseline for comparison. The dotted line represents the normalized FFT envelope of the current signal for a motor with a broken rotor bar fault. This line shows the presence of fault signatures in the frequency spectrum.

The main graph shows prominent peaks at the supply frequency (around 50 Hz) and sidebands at specific frequencies. These sidebands are characteristic of broken rotor bar faults.

Indeed, the dotted line (BRB fault) shows significant amplitude variations at the fault characteristic frequencies, which are not present in the solid line (healthy motor). This indicates the presence of a broken rotor bar fault.

The normalized FFT envelope provides a clearer representation of the frequency components, making the fault signatures more discernible. The envelope detection algorithm effectively highlights the differences between the healthy and faulty conditions.

Another aspect of this disclosure consists in proposing an indicator for detecting these faults, such as misalignment faults or broken rotor bars faults and for monitoring their evolution over time. After computing the FFT envelope 17 of the electric input signal 10 according to the block diagram of Fig. 1, the total energy of the fault signature is calculated. This total energy represents the summation of the harmonic fault area between the FFT envelope curve (dotted lines on Figures 3 and 5) and the X-Axis. By calculating the total energy of the fault signature, the method captures the cumulative effect of all harmonic components associated with the fault. This approach provides a more comprehensive measure of the fault's presence and severity, enhancing the sensitivity of fault detection.

As may be observed on figures 3 and 5, the area of the faults harmonics increases considerably in the presence of a misalignment fault (figure 3) or of a broken rotor bar fault (figure 5). Summing the harmonic fault area between the RMS envelope curve and the x-axis effectively reduces the impact of noise on the fault detection process. This method emphasizes the dominant frequency components, making the fault signatures more discernible and improving the clarity of the frequency spectrum.

Figures 6, 7, and 8 illustrate, in histogram form, the indicators obtained by calculating the total energy of the envelope output for broken rotor bar (BRB) fault intervals using different types of signals: reactive power, current, and voltage, respectively. Each figure presents the results for various speed references and torque percentages, providing a comprehensive comparison of the fault detection capabilities using different signal types. Furthermore, the indicators are computed for different resolution frequencies to assess the impact of the resolution on the relevance of the indicator. Each bar of the histograms represents the total sum of the fault areas (all of the harmonics) for a given operating point (speed and load) of the induction motor.

Outputting a fault indicator representative of the calculated total energy provides a quantifiable measure of the fault's presence and severity. This fault indicator can be easily monitored and compared against predefined thresholds, enabling automated and objective fault detection.

Figure 6 illustrates the indicator associated to the Reactive Power Signature. Figures 6(a) to 6(e) each represent the envelope output for BRB fault intervals at different speed references (80%, 90%, 95%, 100%, and 105%) and varying torque percentages (80%, 90%, 95%, and 100%). The horizontal axis represents the torque percentage. The vertical axis represents the envelope output values. The legend indicates the different conditions (Healthy and Faulty) at various resolution frequencies (2kHz, 4kHz, 6kHz).

Figure 7 illustrates the indicator associated to the Current Signature. Figures 7(a) to 7(e) each represent the envelope output for BRB fault intervals at different speed references (80%, 90%, 95%, 100%, and 105%) and varying torque percentages (80%, 90%, 95%, and 100%). The horizontal axis represents the torque percentage. The vertical axis represents the envelope output values. The legend indicates the different conditions (Healthy and Faulty) at various resolution frequencies (2kHz, 4kHz, 6kHz).

Similar to Figures 6 and 7, Figure 8 illustrates the indicator associated to the Voltage Signature. Figures 8(a) to 8(e) each represent the envelope output for BRB fault intervals at different speed references (80%, 90%, 95%, 100%, and 105%) and varying torque percentages (80%, 90%, 95%, and 100%). The horizontal axis represents the torque percentage. The vertical axis represents the envelope output values. The legend indicates the different conditions (Healthy and Faulty) at various resolution frequencies (2kHz, 4kHz, 6kHz).

As may be observed on Figure 6, the envelope output values for reactive power signals show distinct differences between healthy and faulty conditions, with higher values for faulty conditions, especially at higher torque percentages. By comparison, the envelope output values for current signals on Figure 7 and for voltage signals on Figure 8 also show clear distinctions between healthy and faulty conditions, but the overall values are lower compared to reactive power signals of Figure 6. Using the reactive power signal allows to derive the most relevant indicator, as compared to current or voltage signal, to detect broken rotor bar faults in an induction motor. It could be shown, similarly, that the most relevant indicator for detecting misalignment fault is obtained when using the active power signal.

Across all figures, the envelope output values increase with higher speed references and torque percentages, indicating a stronger fault signature at these conditions, which makes it easier to detect BRB faults.

The legend in each figure 6-8 shows the envelope output values at different resolution frequencies (2kHz, 4kHz, 6kHz). As may be observed, the envelope output values vary with the resolution frequency, with certain resolution frequencies showing more significant differences between healthy and faulty conditions. Yet, figures 6-8 show that faults can be efficiently detected whatever the tested resolution frequency.

Figures 6, 7, and 8 collectively demonstrate the effectiveness of using different signal types (reactive power, current, and voltage) for detecting broken rotor bar faults in induction motors, and the robustness of the proposed method to the frequency resolution. Each signal type provides valuable insights, with reactive power signals showing the highest envelope output values, followed by voltage and current signals. The comparison across different speed references, torque percentages and frequency resolutions highlights the robustness of the fault detection method, making it a reliable tool for predictive maintenance in industrial applications.

The technical solutions presented here are interesting in that they can directly use the electric signals provided by electric sensors which are already embedded in the motor drive, without the need for additional specific sensors.

The indicators can then be compared to determined thresholds to decide whether or not they represent a significant fault of the induction motor. The values of the thresholds may be derived through use of a deep learning algorithm and may depend on the type of induction motor or on its use context.

Figure 9 is a block diagram of a system 100 for detecting faults in an induction motor. The system is designed to process the input signal 10 from the induction motor, analyze it, and detect faults such as misalignment and broken rotor bars.

System 100 comprises a Signal Acquisition Module 101, which is responsible for receiving the input signal from the induction motor. The input signal can be a voltage signal, a current signal, or a power signal (active or reactive). The signal acquisition module captures this signal, which contains information about the motor's operational state.

The memory component 102 stores the acquired signal data and any intermediate processing results. It provides the necessary storage for the system to perform complex calculations and analyses.

The processing unit 103 is the core component responsible for transforming the input signal 10 into the frequency domain using Fast Fourier Transform (FFT). It applies the envelope detection algorithm to the FFT spectrum, calculates the Root Mean Square (RMS) of the envelope, and analyzes the calculated RMS envelope to detect fault signatures. The processing unit 103 performs the necessary computations to identify the presence of faults in the induction motor.

According to an embodiment, system 100 may also comprise a Fault Indicator Module 104, which calculates the total energy of the fault signature by summing the harmonic fault area between the FFT envelope curve and the x-axis. Fault Indicator Module 104 may output a fault indicator representative of the calculated total energy and compare the fault indicator with a threshold to detect a fault when the fault indicator is over the threshold. The fault indicator module 104 provides a clear indication of the presence and severity of faults in the induction motor.

According to an embodiment, system 100 may also comprise a User Interface 105 which displays the fault detection results to an operator. It provides a visual representation of the detected faults and their severity, allowing the operator to take appropriate maintenance actions. The user interface ensures that the system's outputs are easily accessible and interpretable by the user.

System 100 is capable of real-time fault detection, providing timely and accurate information about the condition of the induction motor. Indeed, the input signal 10 from the induction motor is first captured by the signal acquisition module 101. The data is then stored in memory 102 and processed by the processing unit 103. The fault indicator module 104 may analyze the processed data and generate fault indicators, which may be displayed to the operator via user interface 105.

## Industrial Applicability

This disclosure is not limited to the detection of misalignment faults or broken rotor bar faults described here, which are only examples. The invention encompasses every alternative that a person skilled in the art would envisage when reading this text. Notably, the technical solutions presented here can be used to detect any fault with a frequency signature affecting an induction motor.

## Citation List

## Non-Patent Literature

For any purpose, the following non-patent element is cited: - Young-Jun Yoo, "Fault Detection of Induction Motor Using Fast Fourier Transform with Feature Selection via Principal Component Analysis", International Journal of Precision Engineering and Manufacturing, vol. 20, no. 9, pp. 1543-1553, 2019.

## Claims

1. Method for detecting faults in an induction motor, comprising:

   receiving an input signal (10) from the induction motor;
   transforming the input signal (10) into the frequency domain using a Fast Fourier Transform, FFT (11), to obtain an FFT spectrum;
   applying an envelope detection algorithm (12-15) to the FFT spectrum to obtain an envelope representing amplitude variations of frequency components of the FFT spectrum;
   calculating (16) the Root Mean Square, RMS, of the envelope;
   analyzing the calculated RMS envelope (17) to detect at least one frequency signature representative of a fault in the induction motor, called a fault signature.

2. The method for detecting faults according to the preceding claim, wherein applying an envelope detection algorithm to the FFT spectrum comprises:

   - rectifying (12) the FFT spectrum;
   - smoothing (15) the rectified FFT spectrum with a low-pass filter to obtain the envelope.

3. The method for detecting faults according to claim 1 or 2, wherein said detected faults belong to the group comprising:

   - misalignment faults;
   - broken rotor bar faults.

4. The method for detecting faults of any preceding claim, wherein analyzing the calculated RMS envelope comprises:

   - calculating a total energy of the at least one fault signature by summing an harmonic fault area between a curve representative of the RMS envelope and an x-axis;
   - outputting a fault indicator representative of the calculated total energy;
   - comparing said fault indicator with a threshold to detect a fault when said fault indicator is over the threshold.

5. The method for detecting faults of any preceding claim, wherein the input signal (10) belongs to the group comprising:

- a voltage signal;
- a current signal;
- a reactive power signal
- an active power signal.

6. The method for detecting faults according to any preceding claim, wherein the FFT spectrum is normalized before applying the envelope detection algorithm.

7. A system (100) for detecting faults in an induction motor, comprising:

a signal acquisition module (101) configured to receive an input signal (10) from the induction motor;
a processing unit (103) configured to:

transform the input signal into the frequency domain using a Fast Fourier Transform, FFT, to obtain an FFT spectrum;
apply an envelope detection algorithm to the FFT spectrum to obtain an envelope representing amplitude variations of frequency components of the FFT spectrum;
calculate the Root Mean Square, RMS, of the envelope;
analyze the calculated RMS envelope to detect at least one frequency signature representative of a fault in the induction motor, called a fault signature.

8. The system (100) for detecting faults according to claim 7, wherein the processing unit (103) is further configured to calculate a total energy of the at least one fault signature by summing an harmonic fault area between a curve representative of the RMS envelope and an x-axis, and wherein the system (100) further comprises a fault indicator module (104) configured to output a fault indicator representative of the calculated total energy and compare the fault indicator with a threshold to detect a fault when the fault indicator is over the threshold.

9. The system (100) for detecting faults according to claim 8, further comprising a user interface (105) configured to display fault detection results to an operator.

10. The system (100) for detecting faults according to any of claims 7 to 9, further configured to implement the method for detecting faults according to any of claims 1 to 6.

11. Computer software comprising instructions to implement at least a part of a method according to one of claims 1 to 5 when the software is executed by a processor.

12. Computer-readable non-transient recording medium on which a software is registered to implement a method according to one of claims 1 to 5 when the software is executed by a processor.

**Fig. 1**

**Fig. 2**

**Fig. 3**

Comparison of FFT and its envelope for the current signal of a faulty motor with broken rotor bar fault. fs denotes the supply frequency, and s represents the slip.

**Fig. 4**

Comparison of the FFT envelope between a healthy motor and one
with BRB fault: a zoom-in on the fault signature frequency

# Fig. 5

# Fig. 6

Envelope Output for BRB fault interval - Reactive Power Signal-

Fig. 6

Envelope Output for BRB fault interval - Current Signal-

Fig. 7

EP 4 760 289 A1

16

Fig. 7

Fig. 8

Fig. 8

**Fig. 9**

Europäisches
Patentamt

European
Patent Office

Office européen
des brevets

## EUROPEAN SEARCH REPORT

**Application Number**

EP 24 30 7092

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 3 557 050 B1 (ZHEJIANG WINDEY CO LTD [CN]) 15 March 2023 (2023-03-15) * figures 1, 2, 5, 6 * ----- | 1-12 | INV. G01R31/34 |
| A | US 2010/301792 A1 (TIWARI ARVIND KUMAR [IN] ET AL) 2 December 2010 (2010-12-02) * para. 9, 86-89, 94; figures 1-3, 10-15 * ----- | 1-12 | |
| A | US 2018/059188 A1 (MAGONI STEFANO [IT] ET AL) 1 March 2018 (2018-03-01) * paragraph [0120] - paragraph [0147]; figures 1-5, 7, 8 * ----- | 1-12 | |

**TECHNICAL FIELDS SEARCHED (IPC)**

G01R

The present search report has been drawn up for all claims

| Place of search | Date of completion of the search | Examiner |
|---|---|---|
| Munich | 29 April 2025 | Agerbaek, Thomas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
.......................................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 30 7092

This annex lists the patent family members relating to the patent documents cited in the above-mentioned European search report.
The members are as contained in the European Patent Office EDP file on
The European Patent Office is in no way liable for these particulars which are merely given for the purpose of information.

29-04-2025

| Patent document cited in search report | | Publication date | Patent family member(s) | | | Publication date |
|---|---|---|---|---|---|---|
| EP 3557050 | B1 | 15-03-2023 | CN | 106523299 | A | 22-03-2017 |
| | | | DK | 3557050 | T3 | 01-05-2023 |
| | | | EP | 3557050 | A1 | 23-10-2019 |
| | | | ES | 2942286 | T3 | 31-05-2023 |
| | | | WO | 2018107726 | A1 | 21-06-2018 |
| US 2010301792 | A1 | 02-12-2010 | US | 2010301792 | A1 | 02-12-2010 |
| | | | WO | 2010138246 | A1 | 02-12-2010 |
| US 2018059188 | A1 | 01-03-2018 | EP | 3073634 | A1 | 28-09-2016 |
| | | | ES | 2684319 | T3 | 02-10-2018 |
| | | | US | 2018059188 | A1 | 01-03-2018 |
| | | | WO | 2016150680 | A1 | 29-09-2016 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **YOUNG-JUN YOO**. Fault Detection of Induction Motor Using Fast Fourier Transform with Feature Selection via Principal Component Analysis. *International Journal of Precision Engineering and Manufacturing*, 2019, vol. 20 (9), 1543-1553